# EUROPÄISCHE PATENTSCHRIFT

(11) **EP 1 099 224 B1**
(45) Veröffentlichungstag und Bekanntmachung des Hinweises auf die Patenterteilung: **03.07.2002**
(21) Anmeldenummer: 99955733.3
(22) Anmeldetag: 17.09.1999
(51) Int. Cl.: G11C 11/22

(54) **SCHALTUNGSANORDNUNG ZUR GENERIERUNG EINER REFERENZSPANNUNG FÜR DAS AUSLESEN EINES FERROELEKTRISCHEN SPEICHERS**
CIRCUIT FOR GENERATING A REFERENCE VOLTAGE FOR READING OUT FROM A FERROELECTRIC MEMORY
ENSEMBLE CIRCUIT POUR LA GENERATION D'UNE TENSION DE REFERENCE PERMETTANT LA LECTURE D'UNE MEMOIRE FERROELECTRIQUE

(30) Priorität: 25.09.1998 DE 19844101
(43) Veröffentlichungstag der Anmeldung: 16.05.2001
(73) Patentinhaber: Infineon Technologies AG, 81669 München (DE)
(72) Erfinder: BRAUN, Georg, D-80339 München (DE); HÖNIGSCHMID, Heinz, D-82319 Starnberg (DE); RÖHR, Thomas, D-85609 Aschheim (DE); KOWARIK, Oskar, D-85579 Neubiberg (DE); HOFFMANN, Kurt, D-82024 Taufkirchen (DE)
(74) Vertreter: Kottmann, Heinz Dieter, Dipl.-Ing.
(86) Internationale Anmeldenummer: DE9902984
(87) Internationale Veröffentlichungsnummer: WO0019443

(56) Entgegenhaltungen:
- US-A- 5 621 680
- US-A- 5 978 250

## Beschreibung

Die vorliegende Erfindung betrifft eine Schaltungsanordnung zur Generierung einer Referenzspannung für das Auslesen und Bewerten von aus Speicherzellen eines ferroelektrischen Speichers mit konstanter Plattenspannung über Bitleitungen ausgelesenen Lesesignalen, mit einer Referenzspannungseinrichtung und einer an die Bitleitungen angeschlossenen Auswahl- und Bewertungseinrichtung.

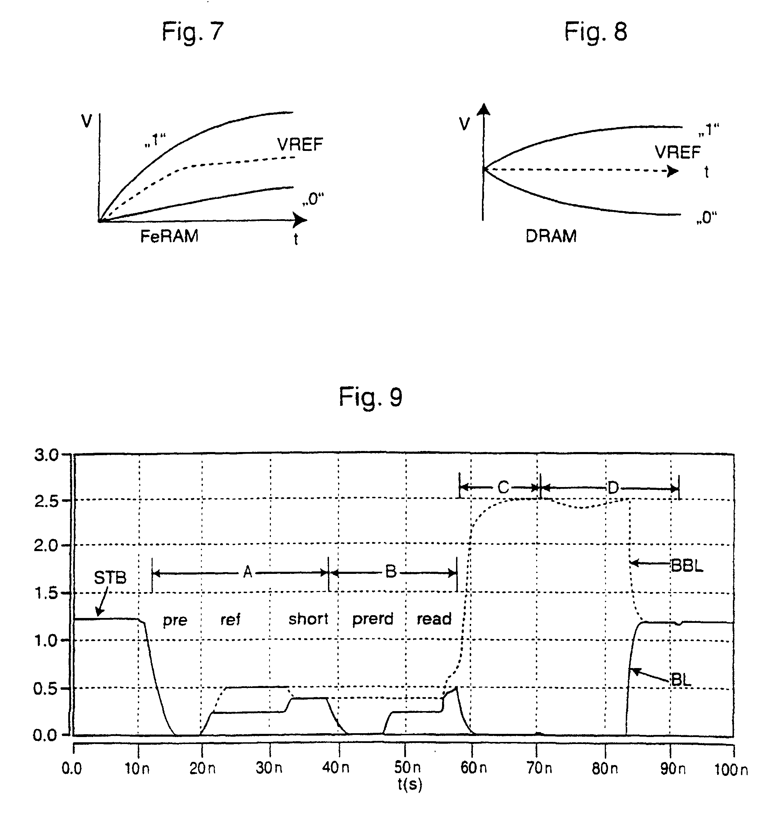

Bei dynamischen Schreib/Lesespeichern (DRAMs) liegt ein Lesesignal bekanntlich oberhalb oder unterhalb eines Referenzpegels mit dem Wert 0. Dies ist schematisch in Fig. 8 veranschaulicht, in der der zeitliche Verlauf eines Lesesignales "1" bzw. eines Lesesignales "0" gezeigt ist. Der Spannungswert V ist in diesem Beispiel für "1" größer als VREF und für "0" kleiner als VREF. Die Erzeugung des Referenzsignales VREF mit 0 V oder nahezu 0 V ist hier relativ einfach.

Bei ferroelektrischen Speichern (FeRAM) liegen die Verhältnisse dagegen komplizierter: beide Lesesignale für "1" und für "0" sind hier größer als 0 V und haben einen schematisch in Fig. 7 gezeigten Verlauf der Spannung V in Abhängigkeit von der Zeit t. Ein immer in der Mitte zwischen "0" und "1" liegendes Referenzsignal VREF ist aufgrund dieses gleichsinnigen Verlaufes der beiden Lesesignale für "1" und "0" schwieriger zu erzeugen als bei DRAMs.

Um dieses Problem zu lösen, wurden deshalb zunächst bei FeRAMs Doppelzellen (sog. 2T2C-Zellen) eingesetzt, die aus zwei jeweils einen Transistor (T) und einen Kondensator (C) aufweisenden Zelle bestehen. In die erste Zelle wird dabei das zu speichernde Signal geschrieben, während in die zweite Zelle das hierzu komplementäre Signal, also das sogenannte Komplementsignal eingegeben wird. Beide Signale stehen dann beim Auslesen zur Verfügung. Der Nachteil dieses Vorgehens liegt einerseits in einem relativ großen Flächenverbrauch und andererseits in einer Verringerung des Rauschabstandes durch den sogenannten "Imprint"-Effekt.

Das Problem eines großen Flächenbedarfs kann zwar an sich durch Einzelzellen (1T1C-Zellen) mit einem Transistor und einem Kondensator gelöst werden. Die lTlC-Zellen können so eine prinzipiell ähnliche Speicherdichte wie bei DRAMs erreichen, benötigen aber eine Referenzzelle zur Generierung des Referenzsignales (vgl. hierzu H. Koike u.a.: "A 60ns 1-Mb Nonvolatile Ferroelectric Memory with a Nondriven Cell Plate Line Write/Read", IEEE J. of solid-state circuits, Band 31, Nr. 11, November 1996, Seiten 1625-1634). Wird diese bekannte 1T1C-Zelle in ähnlicher Weise wie die Zellen von DRAMs eingesetzt, so muß die Zellkapazität Cᵣ der Referenzzelle anders ausgelegt werden als die Zellkapazität Cₛ der eigentlichen Speicherzelle. Nachteilhaft ist nun, daß eine Feineinstellung der Zellkapazität Cᵣ erforderlich ist, um tatsächlich eine exakte Referenzspannung VREF als arithmetischen Mittelwert der beiden Spannungen V1 und V0 für "1" bzw. "0" zu erhalten, was aufgrund von Technologieschwankungen und anderer Einflüsse immer zu einem Lesesignalverlust an einem Bewerter führt. Dies ist vor allem bei niedrigen Versorgungsspannungen ungünstig. Ebenso können unterschiedliche Alterungseffekte von Speicherzelle und Referenzzelle nachteilhaft sein.

Diese Nachteile werden bei einer anderen Lösung des obigen Problems vermieden (vgl. H. Hirano u.a.: "2V/100ns 1T/1C Nonvolatile Ferroelectric Memory Architecture with Bitline-Driven Read Scheme...", IEEE J. of solid-state circuits, Band 32, Nr. 5, Mai 1997, Seiten 649-654), bei der eine Alterung der Speicherzelle dadurch vermieden wird, daß diese immer bei 0 V auf einem nicht polarisierten Zustand gehalten wird. Dies geschieht dadurch, daß beim Zurücksetzen der Referenzzelle eine bestimmte Setzspannung vorgegeben wird. Die Genauigkeit der erzielbaren Referenzspannung ist dann aber abhängig von dieser Setzspannung und deren Temperaturgang.

Allgemein wird bei ferroelektrischen Speichern eine zu lesende Speicherzelle in der Form eines Kondensators mit einem ferroelektrischen Dielektrikum beispielsweise aus Wismuthbariumtantalat (SBT) oder Bleizirkoniumtitanat (BZT) mittels eines Auswahltransistors mit einer Bitleitung verbunden. Aufgrund der Verhältnisse der Kapazitäten ergibt sich auf der Bitleitung ein Nutzsignal in der Größenordnung von einigen 100 mV. Dieses relativ kleine Nutzsignal wird in einem Leseverstärker auf den vollen Logikpegel für "1" oder "0" verstärkt. Dieser Leseverstärker benötigt aber - worauf bereits oben hingewiesen wurde - die Referenzspannung, die nun idealerweise den Mittelwert der Spannungen darstellen sollte, die man beim Auslesen einer "0" bzw. einer "1" aus einer Speicherzelle erhält (vgl. hierzu nochmals Fig. 7).

Eine solche Referenzspannung VREF kann nun generiert werden, indem auf einem Bitleitungspaar zwei Referenzzellen ausgelesen werden, die eine inverse Information enthalten. Durch anschließendes Kurzschließen des Bitleitungspaares wird dann der arithmetische Mittelwert der beiden zuvor erhaltenen Lesesignale gebildet. Das Referenzsignal wird auf einer der beiden Bitleitungen belassen, während auf der anderen Bitleitung die zu lesende Speicherzelle aktiviert wird. Im Leseverstärker wird dann die ausgelesene Spannung mit der Referenzspannung verglichen und auf den vollen Logikpegel verstärkt.

Ein derartiges Vorgehen erlaubt zwar eine relativ genaue Erzeugung eines Referenzsignales, erfordert aber infolge des seriellen Ablaufes der Generierung der einzelnen Signale eine relativ lange Zeitdauer.

Das sequentielle Erzeugen der Referenzspannung mittels zweier Referenzzellen und das anschließende Lesen der Speicherzelle ist schematisch in dem Signaldiagramm von Fig. 9 veranschaulicht: ein Lesezyklus beginnt beispielsweise bei t = 10 ns mit der negativen Flanke eines Abtast- bzw. Strobe-(STB-)Signales. Es folgt nun die Generierung einer Referenzspannung in einem Zeitraum (A). Hierzu werden zunächst die beiden Bitleitungen auf 0 Volt entladen ("pre"), anschließend werden die beiden Referenzzellen mit inverser Information ausgelesen ("ref"), und schließlich wird durch Kurzschließen der beiden Bitleitungen der arithmetische Mittelwert gebildet ("short"). In einem folgenden Zeitabschnitt "B" wird die zu lesende Bitleitung auf 0 V entladen ("prerd"), und sodann wird die Speicherzelle ausgelesen ("read"). Nun liegt an der zu lesenden Bitleitung eine Spannung an, die je nach Speicherinhalt der Speicherzelle kleiner oder größer als die Referenzspannung ist. Im nachfolgenden Verstärkungsvorgang während eines Zeitraumes "C" wird diese kleine Spannungsdifferenz auf volle Logikpegel verstärkt. Etwa bei t = 70 ns, also etwa 60 ns nach Beginn des Lesezyklus, steht die gelesene Information auf den Bitleitungen BL bzw. BBL zur weiteren Verarbeitung zur Verfügung. Abschließend folgt noch das Zurückschreiben der Information in die Referenzzellen und das Rückführen in den Ruhezustand während eines Zeitraumes "D".

Es ist nun Aufgabe der vorliegenden Erfindung, eine Schaltungsanordnung zur Generierung einer Referenzspannung zu schaffen, bei der trotz Verkürzung des Lesezyklus die Referenzspannung mit genauem Pegel zur Verfügung gestellt werden kann.

Diese Aufgabe wird bei einer Schaltungsanordnung der eingangs genannten Art erfindungsgemäß dadurch gelöst, daß die Referenzspannungseinrichtung aus zwei mit komplementären Signalen beaufschlagbaren Referenzzellen besteht, die gleichzeitig zur Generierung der Referenzspannung in die Auswahl- und Bewertungseinrichtung auslesbar sind.

Bei der erfindungsgemäßen Schaltungsanordnung werden also gleichzeitig zwei Referenzzellen verwendet. Diese beiden Referenzzellen werden vor Beginn des Lesevorgangs über zwei Leitungen auf "1" bzw. auf "0" vorgeladen, so daß in der einen Referenzzelle eine Spannung entsprechend "1" und in der anderen Referenzzelle eine Spannung entsprechend "0" gespeichert ist. Sodann werden beide Referenzzellen gleichzeitig bei Beginn des Lesevorgangs auf eine Referenzbitleitung ausgegeben, so daß sie eine genaue Referenzspannung VREF auf der Referenzbitleitung einstellt.

In einer bevorzugten Ausführungsform kann das Rückschreiben von "1" bzw. "0" in die Referenzzellen über speziell vorgesehene Versorgungsleitungen erfolgen.

Eine andere bevorzugte Ausführungsform der Erfindung sieht vor, daß die Referenzzellen jeweils über die Bitleitungen selbst wiederaufladbar sind, wozu geeignete Schaltungsmaßnahmen ergriffen werden: Jede Referenzzelle ist über jeweils einen durch eine Wortleitung angesteuerten Auswahltransistor an jede der beiden Bitleitungen des Bitleitungspaares anschließbar.

In einer anderen vorteilhaften Ausgestaltung der Erfindung sind beide Referenzzellen mit einem weiteren Bitleitungspaar verbunden und über jeweils einen Auswahltransistor zu der Auswahl- und Bewertungseinrichtung auslesbar.

Dadurch ist es möglich, das Lese- bzw. Nutzsignal aus der Speicherzelle nicht nach, sondern vielmehr gleichzeitig mit der Referenzspannung zu generieren. Die Referenzspannung wird also nicht auf demjenigen Bitleitungspaar erzeugt, auf dem auch die zu lesende Speicherzelle angesteuert wird. Vielmehr wird für die Erzeugung der Referenzspannung ein Bitleitungspaar in einem anderen Array verwendet, auf dem wiederum zwei Referenzzellen mit inverser Information auslesbar sind. Durch anschließendes Kurzschließen des Bitleitungspaares wird wieder der arithmetische Mittelwert der beiden Signale erhalten. Gleichzeitig mit dieser Erzeugung der Referenzspannung wird auch die eigentliche Speicherzelle in einem von dem Array der Referenzzellen verschiedenen Array ausgelesen. Durch entsprechend angesteuerte Auswahltransistoren werden das Lesesignal und das Referenzsignal auf die Eingänge eines Leseverstärkers geschaltet und dort verstärkt.

Durch diese "Parallelisierung" des Lesevorganges wird eine erhebliche Verkürzung des Lesezugriffes erreicht. Auch werden hier keine zusätzlichen Bitleitungen benötigt, da zur Generierung der Referenzspannung inaktive Bitleitungspaare in einem anderen Array ausgenutzt werden können.

Nachfolgend wird die Erfindung anhand der Zeichnungen näher erläutert. Es zeigen:
Fig. 1 ein Schaltbild eines ersten Ausführungsbeispiels der Erfindung,
Fig. 2 ein Diagramm zur Erläuterung des Signalverlaufes bei dem Ausführungsbeispiel von Fig. 1,
Fig. 3 ein Schaltbild eines zweiten Ausführungsbeispiels der Erfindung,
Fig. 4 ein Diagramm zur Erläuterung des Signalverlaufs bei dem Ausführungsbeispiel von Fig. 3,
Fig. 5 ein Schaltbild für ein drittes Ausführungsbeispiel der Erfindung,
Fig. 6 ein Diagramm zur Erläuterung des Signalverlaufs beim Ausführungsbeispiel von Fig. 5,
Fig. 7 ein Diagramm zur Erläuterung der Einstellung der Bezugsspannung VREF bei einem FeRAM,
Fig. 8 ein Diagramm zur Erläuterung der Referenzspannung VREF bei einem DRAM und
Fig. 9 ein Diagramm zur Erläuterung des Signalverlaufs bei einer bestehenden Schaltungsanordnung.

Die Fig. 7 bis 9 sind bereits eingangs erläutert worden. In den Figuren werden für einander entsprechende Bauteile bzw. Signalverläufe jeweils die gleichen Bezugszeichen verwendet.

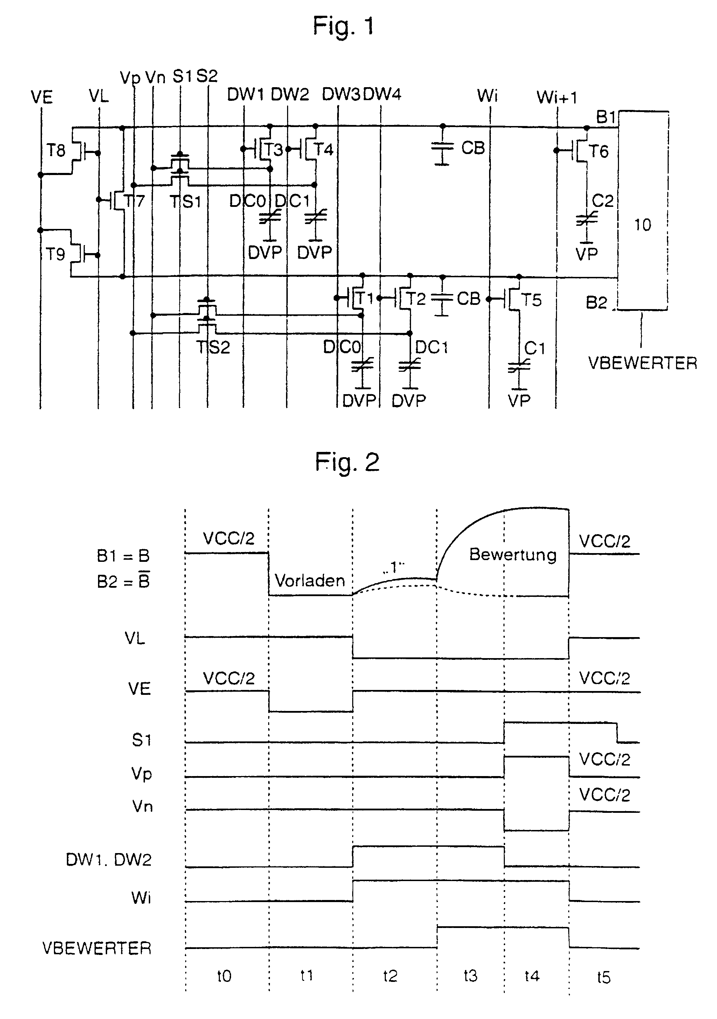

In der Schaltungsanordnung von Fig. 1 werden Bitleitungen B1 und B2 zu einem Zeitpunkt t0 (vgl. Fig. 2) über Vorladeleitungen VE und VL ("Vorladen") jeweils auf dem halben Versorgungsspannungspotential VCC/2 gehalten. Hierzu sind die Bitleitungen B1 bzw. B2 über Transistoren T7, T8 und T9 an die Leitungen VL bzw. VE angeschlossen.

Zu einem Zeitpunkt t1 werden, indem die Leitung VE auf 0 V gebracht wird, die Bitleitungen B1 und B2 auf 0 V vorgeladen.

In einem Zeitpunkt t2 wird durch Schalten von Wortleitungen Wi sowie DW1 und DW2 auf die Bitleitung B2 der Zelleninhalt einer Speicherzelle C1, an der die Plattenspannung VP anliegt, über einen Transistor T5 ausgegeben, während auf die Referenzbitleitung B1 der Inhalt von Referenzzellen DC0, DC1 mit Plattenspannungen DVP über Transistoren T3 und T4 gelegt wird. Damit ergibt sich die Referenzspannung als Mittel zwischen einem "1"-Signal und einem "0"-Signalauf der Referenzbitleitung B1. Versorgungsleitungen S1, S2 für das Nachladen der Referenzzellen DC0, DC1 sind zu diesem Zeitpunkt durch Transistoren TS1, TS2 deaktiviert.

Sind die Bitleitung und die Referenzbitleitung vertauscht, bildet also B1 eine Bitleitung und B2 eine Referenzbitleitung, so werden Wortleitungen Wi+1 sowie DW3 und DW4 aktiviert. Der übrige Betrieb erfolgt in entsprechender Weise, wie dies oben erläutert wurde. Die Speicherzelle wird in diesem Fall durch den Speicherkondensator C2 gebildet.

In einem Zeitpunkt t3 wird über ein Bewertersignal VBEWERTER eine Auswahl- und Bewertereinrichtung 10 aktiviert; im dargestellten Fall wird die auf der Bitleitung B2 ausgelesene "1" auf die Spannung VCC verstärkt, und die Referenzbitleitung B1 wird nach 0 V gezogen. Bei Auslesen einer "0" erfolgt der Vorgang gerade umgekehrt.

Indem in einem Zeitpunkt t4 die Versorgungsleitung S1 auf VCC, die Leitung Vp auf VCC und die Leitung Vn auf 0 V gesetzt werden, können die Referenzzellen DC1 und DC0 auf "1" bzw. "0" polarisiert werden.

Schließlich werden in einem Zeitpunkt t5 alle Wortleitungen DW1, DW2, DW3, DW4, Wi, Wi+1 deaktiviert, das Signal auf der Leitung VL wird auf VCC gesetzt, und das Signal auf der Leitung VE wird auf VCC/2 gesetzt, so daß die Bitleitungen B1, B2 auf VCC/2 liegen. Indem schließlich die Leitung S1 auf VCC und die Leitungen Vp und Vn auf VCC/2 gebracht werden, wird die Spannung an den Referenzzellen DC0, DC1 auf 0 V gesetzt, da die Plattenspannung VP auf VCC/2 liegt.

Um ein Ungleichgewicht in den Kapazitäten der Bitleitung B2 und der Referenzbitleitung B1 zu vermeiden, werden die Kapazitäten der Referenzzellen DC0, DC1 nur halb so groß gewählt wie Kapazitäten CB der Speicherzellen. Ist aus Gründen des Layouts eine Halbierung der Kapazität der Referenzzellen DC0, DC1 nicht möglich, so wird die Zellplattenspannung VP gleichzeitig so eingestellt, daß ein kapazitives Ungleichgewicht kompensiert wird.

Die Schaltungsanordnung des Ausführungsbeispiels der Fig. 1 und 2 ermöglicht speziell die folgenden Vorteile:
- Die Schaltungsanordnung ist im Vergleich zu bestehenden Referenzspannungsschaltungen sehr schnell.
- Die Referenzspannung VREF liegt genau zwischen einer "1" und einer "0".
- Die Referenzspannung VREF ist relativ unempfindlich gegenüber Temperaturschwankungen.
- Die Referenzspannung VREF ist relativ unempfindlich gegen Alterungseinflüsse und Ermüdung; dies ist zweckmäßig, da die Referenzzellen DC0, DC1 in der Regel wesentlich häufiger umprogrammiert werden als normale Speicherzellen.
- Durch Verschiebung der Plattenspannung VP und/oder DVP kann die Referenzspannung zum Beispiel beim Testen des FeRAMs beispielsweise über Laserverbindung zum Einstellen der Plattenspannung VP noch justiert werden.
- Bei dem vorliegenden Ausführungsbeispiel werden also zwei Referenzzellen DC0, DC1 auf eine Bitleitung B1 gleichzeitig mit dem Auslesen des Speichersignals gegeben, um so eine Referenzspannung zu generieren. Ein spezieller Vorteil liegt darin, daß das Auslesen schnell und präzise erfolgen kann. Das Rückschreiben von "1" und "0" in die Referenzzellen erfolgt über speziell vorgesehene Versorgungsleitungen. Zu den üblichen ferroelektrischen Speicherzellen werden somit zwei Referenzzellen mit einer "1" und einer "0" hinzugefügt, wobei diese Referenzzellen so geschaltet sind, daß sich eine präzise Referenzspannung VREF ergibt.

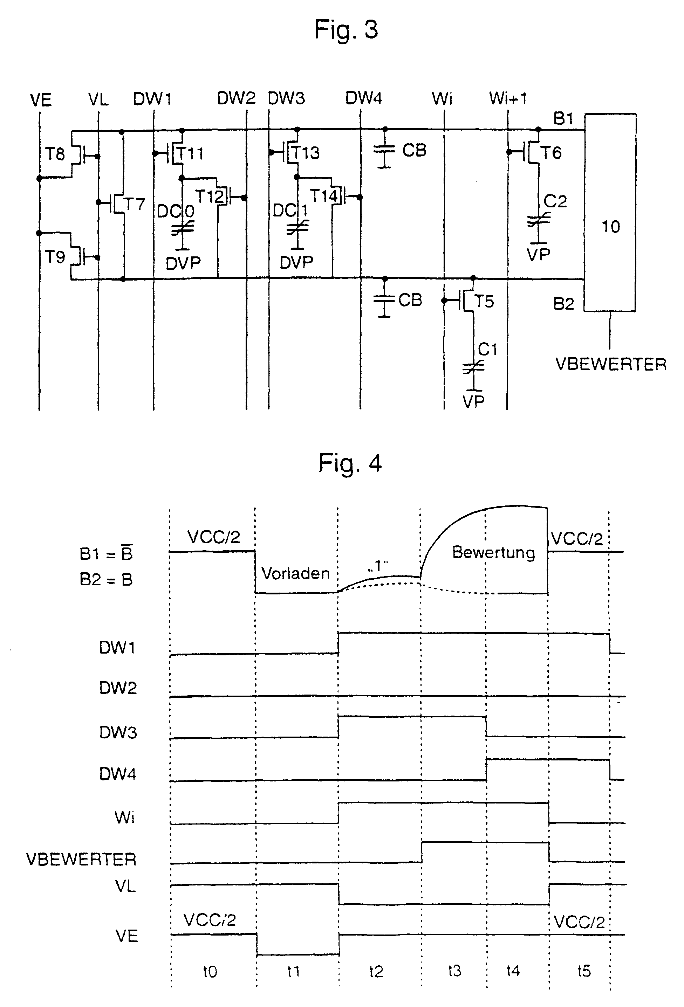

Anhand der Fig. 3 und 4 wird nunmehr im folgenden ein weiteres Ausführungsbeispiel der erfindungsgemäßen Schaltungsanordnung erläutert. Auch bei diesem Ausführungsbeispiel werden die Bitleitungen B1, B2 in einem Zeitpunkt t0 über die Vorladeleitungen VE bzw. VL auf der halben Versorgungsspannung VCC/2 gehalten.

In einem Zeitpunkt t1 wird die Vorladeleitung VE auf 0 V gebracht, um so die Bitleitungen B1 und B2 auf 0 V vorzuladen.

In einem Zeitpunkt t2 werden durch Schalten der Wortleitungen Wi sowie DW1 und DW3 auf die Bitleitung B2 der Speicherzelleninhalt der Speicherzelle C1 über den Transistor T5 und auf die Referenzbitleitung B1 der Referenzzelleninhalt der Referenzzellen DC0, DC1 ausgegeben, so daß die Referenzspannung als Mittel zwischen dem "1"-Signal und dem "0"-Signal auf der Referenzbitleitung B2 erhalten wird.

Sind, wie im Beispiel der Fig. 1 und 2, die Bitleitung und die Referenzbitleitung vertauscht, so daß die Leitung B1 die Bitleitung und die Leitung B2 die Referenzbitleitung ist, so werden die Wortleitungen Wi+1 und DW2 sowie DW4 aktiviert.

In einem Zeitpunkt t3 wird über das Bewertersignal VBEWERTER die Auswahl- und Bewertereinrichtung 10 aktiviert, und im dargestellten Fall wird die ausgelesene "1" auf der Bitleitung B2 auf die Spannung VCC verstärkt, während die Referenzbitleitung B1 auf 0 V gezogen wird. Beim Auslesen einer "0" erfolgt der Vorgang umgekehrt.

In einem Zeitpunkt t4 werden zum Rückschreiben des richtigen Signals in die Referenzzelle DC1 die Wortleitung DW3 deaktiviert, und die Wortleitung DW4 wird aktiviert. Sind die Bitleitung und die Referenzbitleitung umgekehrt, bildet also B1 die Bitleitung und B2 die Referenzbitleitung, so wird die Wortleitung DW1 deaktiviert, und die Wortleitung DW2 wird aktiviert.

In einem Zeitpunkt t5 wird die Wortleitung Wi deaktiviert, und die Vorladeleitung VL wird auf VCC gesetzt, während die Vorladeleitung VE auf VCC/2 gebracht ist. Dadurch liegen die Bitleitungen B1, B2 auf VCC/2. Indem die Wortleitungen DW1 und DW4 aktiviert werden, wird die Spannung an den Referenzzellen DC0, DC1 auf 0 V gesetzt, da die Plattenspannung VP auf VCC/2 liegt. Anschließend werden alle Wortleitungen DW1, DW2, DW3, DW4, Wi, Wi+1 deaktiviert.

Für das Aufladen und Entladen der Referenzzellen DC0, DC1 können über die jeweiligen Wortleitungen DW1, DW2, DW3 und DW4 Schalttransistoren T11, T12, T13, T14 angesteuert werden, die die Referenzzellen dann mit den Bitleitungen B1 bzw. B2 verbinden bzw. von diesen trennen.

Um ein Ungleichgewicht in den Kapazitäten der Bitleitung B2 und der Referenzbitleitung B1 (oder umgekehrt) zu vermeiden, werden, ähnlich wie beim Ausführungsbeispiel der Fig. 1 und 2, die Referenzzellen DC0 und DC1 nur halb so groß gewählt wie die Speicherzellen CB. Ist aus Gründen des Layouts auch hier eine Halbierung der Kapazität der Referenzzellen DC0, DC1 nicht möglich, so wird die Plattenspannung DVP und/oder VP gleichzeitig so eingestellt, daß ein kapazitives Ungleichgewicht kompensiert wird.

Ähnlich wie das Ausführungsbeispiel der Fig. 1 und 2 bietet auch das vorliegende Ausführungsbeispiel der Fig. 3 und 4 speziell die folgenden Vorteile:
- Die Schaltungsanordnung ist im Vergleich zu bestehenden Referenzspannungsschaltungen sehr schnell; die zusätzliche benötigte Zeit t4 geht dabei nicht in die Zugriffszeit ein.
- Die Referenzspannung VREF liegt sehr genau zwischen "1" und "0".
- Die Referenzspannung ist relativ unempfindlich gegenüber Temperaturschwankungen.
- Die Referenzspannung ist relativ unempfindlich gegenüber Alterungseinflüssen und Ermüdung; dies ist zweckmäßig, da die Referenzzellen DC0 und DC1 in der Regel wesentlich häufiger umprogrammiert werden als normale Zellen.
- Durch Verschieben der Plattenspannung VP kann das Referenzsignal beispielsweise beim Testen der FeRAMs über Laserverbindungen zum Einstellen von der Plattenspannung VP noch justiert werden.
- Wie auch beim ersten Ausführungsbeispiel der Fig. 1 und 2 sind nur zwei Referenzzellen pro Bitleitungspaar erforderlich.

Beim Ausführungsbeispiel der Fig. 2 erfolgt das Wiederaufladen der Referenzzellen im Gegensatz zum Ausführungsbeispiel der Fig. 1 über spezielle geeignete Schaltungsmaßnahmen (vgl. die Transistoren T11 bis T14) über das Zurückschreiben aus den Bitleitungen B1 und B2.

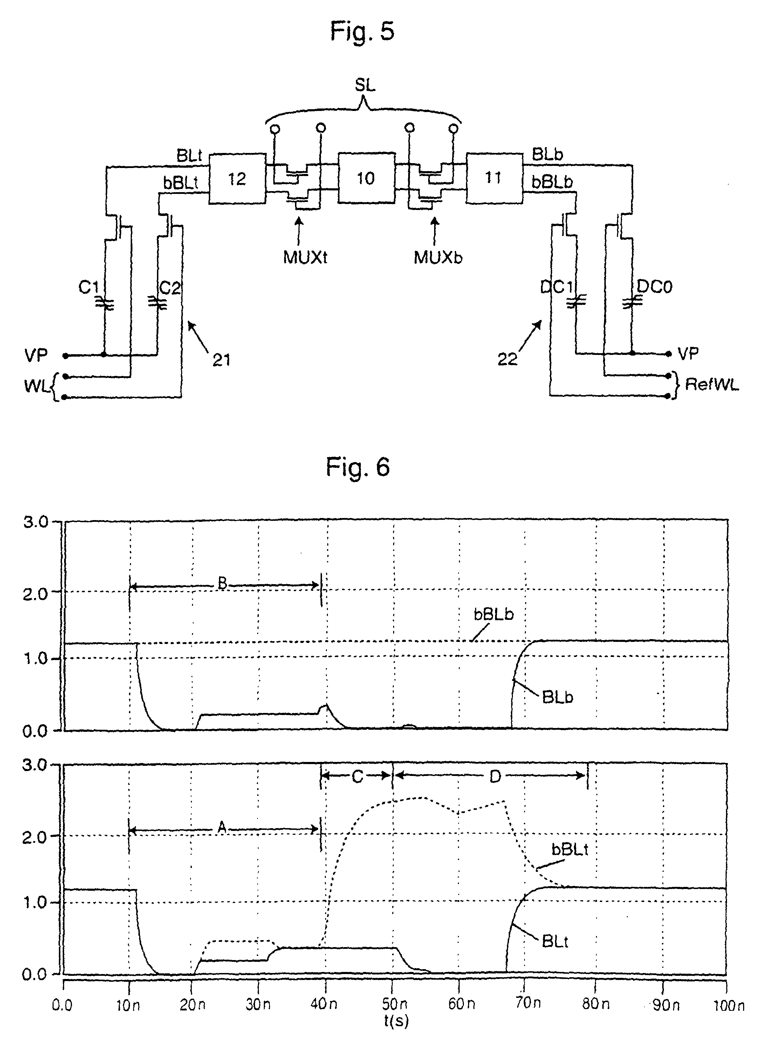

Im folgenden wird anhand der Fig. 5 und 6 ein weiteres bevorzugtes Ausführungsbeispiel der vorliegenden Erfindung erläutert.

Bei diesem Ausführungsbeispiel liegt ein Leseverstärker als Auswahl- und Bewertungseinrichtung 10 ähnlich wie bei DRAMs zwischen zwei Speicherarrays 21, 22 und wird von diesen Speicherarrays 21, 22 genutzt. Die Referenzzellen DC0 und DC1 und die zu lesenden bzw. Speicherzellen sind an unterschiedlichen Bitleitungspaaren BLb/bBLb bzw. BLt/bBLt angeschlossen. Auswahltransistorenpaare MUXb bzw. MUXt sind hier - was wesentlich ist - im Unterschied zum Stand der Technik aufgetrennt, so daß sich insgesamt vier Auswahltransistoren für die beiden Bitleitungspaare ergeben, die dem Leseverstärker vorgeschaltet sind. Durch diese Auftrennung der Auswahltransistoren ist das gleichzeitige Generieren der Referenzspannung (vgl. beispielsweise die rechte Hälfte der Fig. 5) und das Auslesen der Speicherzelle (vgl. die linke Hälfte der Fig. 5) über Schalteinrichtungen 11, 12 möglich. Hierzu werden die Auswahltransistoren der Speicherzellen sowie der Referenzzellen und die Auswahltransistoren MUXb bzw. MUXt über Wortleitungen WL und Steuerleitungen SL angesteuert.

Der Lesevorgang beginnt beispielsweise in einem Zeitpunkt t = 10 ns mit der negativen Flanke des Strobe- bzw. Abtastsignales (vgl. Fig. 6). Die Generierung der Referenzspannung in einem Zeitraum A und das Auslesen der Speicherzelle in einem Zeitraum B werden - was wesentlich ist - gleichzeitig auf elektrisch nicht verbundenen Bitleitungspaaren BLb/bBLb bzw. BLt/bBLt gestartet. Danach wird durch zwei der vier Auswahltransistoren, beispielsweise durch den in Fig. 5 oberen Transistor der Transistoren MUXb und den in Fig. 5 unteren Transistor der Transistoren MUXt, das Lesesignal und das Referenzsignal auf den Leseverstärker geschaltet und das Differenzsignal verstärkt, was in dem Zeitraum C geschieht. Etwa bei t = 50 ns, also 40 ns nach Beginn des Lesezyklus, steht die gelesene Information auf den Bitleitungen zur weiteren Verarbeitung zur Verfügung. Abschließend folgt noch das Zurückschreiben der Information in die Referenzzellen und das Rückführen in den Ruhezustand während des Zeitraumes D.

Wie durch einen Vergleich mit Fig. 9 folgt, kann durch das parallelisierte Leseverfahren die Zeit bis zum Bereitstellen der gültigen Daten von etwa 60 ns auf etwa 40 ns verkürzt werden.

## Patentansprüche

1. Schaltungsanordnung zur Generierung einer Referenzspannung für das Auslesen und Bewerten von aus Speicherzellen eines ferroelektrischen Speichers mit konstanter Plattenspannung über erste Bitleitungspaare (BLt, bBLt) ausgelesenen Lesesignalen, mit einer Referenzspannungseinrichtung (DC1, DC0; 22) und einer an die ersten Bitleitungspaare angeschlossenen Auswahl- und Bewertungseinrichtung (10), wobei die Referenzspannungseinrichtung aus zwei mit komplementären Signalen beaufschlagbaren Referenzzellen (DC0, DC1) besteht, die gleichzeitig zur Generierung der Referenzspannung in die Auswahlund Bewertungseinrichtung (10) auslesbar sind,
**dadurch gekennzeichnet,**
**daß** beide Referenzzellen (DC0, DC1) an jeweils eine Bitleitung (BLb, bBLb) eines weiteren Bitleitungspaares (BLb, bBLb) angeschlossen und über jeweils einen Auswahltransistor (MUXb) zu der Auswahl- und Bewertungseinrichtung (10) auslesbar sind.

2. Schaltungsanordnung nach Anspruch 1,
**dadurch gekennzeichnet,**
**daß** die Referenzzellen (DC0, DC1) jeweils über eine gesonderte Versorgungsleitung (Vp) wiederaufladbar sind.

3. Schaltungsanordnung nach einem der Ansprüche 1 oder 2,
**dadurch gekennzeichnet,**
**daß** die Kapazität der Referenzzellen (DC0, DC1) der Kapazität einer Speicherzelle (21) entspricht.

## Claims

1. Circuit arrangement for generating a reference voltage for reading out and evaluating read signals read from memory cells of a ferroelectric memory with constant plate voltage via first bit line pairs (BLt, bBLt), having a reference voltage device (DC1, DC0; 22) and a selection and evaluation device (10) connected to the first bit line pairs, the reference voltage device comprising two reference cells (DC0, DC1), to which complementary signals can be applied and which can simultaneously be read for generating the reference voltage into the selection and evaluation device (10),
**characterized**
**in that** the two reference cells (DC0, DC1) are connected to a respective bit line (BLb, bBLb) of a further bit line pair (BLb, bBLb) and can be read via a respective selection transistor (MUXb) to the selection and evaluation device (10).

2. Circuit arrangement according to Claim 1,
**characterized**
**in that** the reference cells (DC0, DC1) can each be recharged via a separate supply line (Vp).

3. Circuit arrangement according to either of Claims 1 and 2,
**characterized**
**in that** the capacitance of the reference cells (DC0, DC1) corresponds to the capacitance of a memory cell (21).

## Revendications

1. Circuit pour la génération d'une tension de référence en vue de la lecture et de l'évaluation de signaux de lecture lus dans des cellules d'une mémoire ferroélectrique à tension de plaque constante par l'intermédiaire de premières paires de lignes de bits (BLt, bBLt), comprenant un dispositif de tension de référence (DC1, DC0 ; 22) et un dispositif de sélection et d'évaluation (10) raccordé aux premières paires de lignes de bits, le dispositif de tension de référence étant constitué de deux cellules de référence (DC0, DC1) auxquelles sont appliqués des signaux complémentaires et qui peuvent être lues simultanément pour la génération de la tension de référence dans le dispositif de sélection et d'évaluation (10),
**caractérisé par le fait que** les deux cellules de référence (DC0, DC1) sont raccordées à une ligne de bit (BLb, bBLb) respective d'une autre paire de lignes de bits (BLb, bBLb) et peuvent être lues par l'intermédiaire d'un transistor de sélection (MUXb) respectif vers le dispositif de sélection et d'évaluation (10).

2. Circuit selon la revendication 1,
**caractérisé par le fait que** les cellules de référence (DC0, DC1) sont rechargeables respectivement par l'intermédiaire d'une ligne d'alimentation (Vp) particulière.

3. Circuit selon l'une des revendications 1 ou 2,
**caractérisé par le fait que** la capacité des cellules de référence (DC0, DC1) correspond à la capacité d'une cellule de mémoire (21).
